# EUROPEAN PATENT APPLICATION

(11) **EP 4 142 437 A1**
(43) Date of publication of application: **01.03.2023**
(21) Application number: 21793284.7
(22) Date of filing: 03.02.2021
(51) Int. Cl.: H05K 3/12, B41M 7/00, B05C 5/02

(54) **DEVICE AND METHOD FOR FORMING CONDUCTIVE MICRO-PATTERNS**

(30) Priority: 20.04.2020 KR 20200047432
(71) Applicant: Unijet Co., Ltd., Seongnam-si, Gyeonggi-do 13203 (KR)
(72) Inventor: KIM, Seog-soon, Seongnam-si Gyeonggi-do 13203 (KR)
(74) Representative: Krauns, Christian
(86) International application number: PCT/KR2021/001408
(87) International publication number: WO 2021/215631

(57) **Abstract**

The present invention relates to an apparatus and a method for forming a conductive fine pattern, wherein all processes are simplified using an inkjet printing method, and thus a substrate having a fine pattern smaller than 20 µm can be quickly manufactured. To this end, the method for forming a conductive fine pattern according to the present invention forms a conductive fine pattern on a substrate having identical surface energy by using inkjet printing for printing ink along a path. The method for forming a conductive fine pattern comprises a droplet ejection process of simultaneously performing: discharging photocurable ink at the front side of the path; discharging volatile ink containing minute metal particles at the rear side of the path; and applying light energy to the discharged photocurable ink, wherein the light energy is configured to have a light intensity such that: the photocurable ink is semi-cured and ejected in a gel state on the substrate, and thus forms a boundary with liquid volatile ink ejected on the substrate; and the photocurable ink is completely cured after the ejection of both the photocurable ink and the volatile ink is completed.

## Description

### TECHNICAL FIELD

The present invention relates to an apparatus and a method for forming a conductive fine pattern, and more particularly, to an apparatus and a method for forming a conductive fine pattern, which are capable of quickly manufacturing a substrate having a fine pattern smaller than 20 µm by simplifying all process using an inkjet printing method.

### BACKGROUND ART

A technology of printing a conductive pattern using an inkjet printing technology is developed at an early stage of development of a printed electronics technology to develop a PCB manufacturing technology using a line width of 80 µm to 150 µm.

However, the inkjet printing technology is not widely used in PCB manufacturing despite of many advantages because the inkjet printing technology hardly achieves a line width with a high thickness in PCB and has expensive manufacturing costs and lower productivity in comparison with a screen printing technology.

Due to this, the current inkjet printing technology is used only in an extremely limited range such as a process of manufacturing a PCB product having a line width of 50 µm to 80 µm with a small quantity and various kinds or a process of manufacturing a PCB sample with a small quantity.

In recent years, a next generation PCB or high density interconnect (HDI) board is manufactured to have a fine pattern smaller than about 20 µm for high integration. Since the screen printing technology has low integration and uniformity and is difficult to be used for manufacturing the highly integrated PCB, the highly integrated PCB or HDI is manufactured by a lithography method or a laser method. Particularly, a high density PCB or HDI for mobile devices is manufactured by an expensive manufacturing method such as the lithography method or the laser method.

On the other hand, the inkjet printing method may directly form a line without using a typical process such as exposure, etching, and plating. The inkjet printing method forms a fine pattern each having a width of several tens µm by discharging a solution or a suspension in the form of a droplet of several picoliters (pL) to several tens pL through micro-nozzles.

Specifically, a surface treatment is performed on a surface of a substrate so that a fine pattern has a hydrophilic property, and the rest portion has a hydrophobic property, and then the fine pattern made of a conductive ink is formed on a portion having the hydrophilic property.

More specifically, the fine pattern is realized by separately forming a hydrophobic area and a hydrophilic area through the lithography method or a method of applying a hydrophobic film, forming a hydrophobic pattern through etching using UV light, and applying a conductive material onto the hydrophobic pattern, and then applying a conductive ink so that all applied inks are collected into the hydrophilic area.

The above-described typical inkjet printing method is gradually and increasingly used due to easy design change, reduction in manufacturing costs of a photomask, and reduction in manufacturing process time.

However, the process of performing the surface treatment on the substrate so that the surface of the substrate has the hydrophobic or hydrophilic property causes high manufacturing costs.

However, since the inkjet printing method may realize an ink droplet having a size of 1 pL (a diameter of 12.6 µm) due to a limitation of a commercialized inkjet head, realization of a fine pattern having a size of 20 µm is substantially impossible by using only the inkjet technology.

Specifically, when the ink droplet having the size of 1 pL (the diameter of 12.6 µm) is discharged and seated on the surface of the substrate, the ink is spread into various sizes based on a surface state. A line width of about three times (35 µm) or about four times (47 µm) of the general ink droplet may be formed in case of a general surface state, or a line width of two times (22 µm) of the ink droplet may be realized when the surface state of the substrate has the hydrophobic property. Substantially, however, realization of a line width smaller than the above-described sizes, which is required in various applied fields, is difficult, and product production using this process is more difficult.

Also, since a thickness of the fine pattern decreases when a size of the ink droplet decreases, realization of the fine pattern having a higher thickness is more difficult. Although the higher thickness is realized, since much transmission loss is generated due to a non-uniform boundary of the fine line pattern, the inkjet printing method may not be used in substantial applied fields.

In some cases, printing is performed by discharging an ink droplet using a heated substrate and drying the ink droplet using heat of the substrate. When the ink is dried by heating the substrate, this may cause evaporation of a solvent contained in the ink inside a nozzle of a head to clog the nozzle of the head, thereby causing poor printing or impossibility of printing itself.

Also, since the method of heating the substrate causes thermal expansion of the substrate itself and the inkjet head, realization of the precise fine pattern is impossible due to an error caused by the thermal expansion.

(Related art: Korean Patent Publication No. 10-2019-0131189, Publication date: November 26, 2019)

### DISCLOSURE OF THE INVENTION

### TECHNICAL PROBLEM

The present invention provides an apparatus and a method for forming a conductive fine pattern, which are capable of quickly manufacturing a substrate having a fine pattern smaller than 20 µm by simplifying all processes using an inkjet printing method.

### TECHNICAL SOLUTION

In order to achieve the technical objects, the present invention provides a method for forming a conductive fine pattern, which forms a conductive fine pattern on a substrate having identical surface energy by using an inkjet printing for printing an ink along a path, including a droplet ejection process of simultaneously performing all of discharging a photocurable ink at a front side of the path, discharging a volatile ink containing minute metal particles at a rear side of the path, and applying light energy to the discharged photocurable ink. Here, an intensity of light of the light energy is set so that the photocurable ink in a semi-cured and gel state is ejected on the substrate to form a boundary with the liquid volatile ink ejected on the substrate and simultaneously prevent the photocurable ink from being spread, thereby being completely cured after all of the photocurable ink and the volatile ink are completely ejected.

In an embodiment, the method may further include a drying process of drying the volatile ink after the droplet ejection process.

In an embodiment, after the drying process, a thick film process of additionally ejecting and drying the volatile ink onto the conductive fine pattern formed by the drying of the volatile ink may be performed at least one time.

In an embodiment, each of the photocurable ink and the volatile ink may be discharged with a droplet size of 2 picoliter (pL) or less, the photocurable ink may be ejected on an insulation area to be formed as a non-conductive area, and the volatile ink may be ejected on a conductive area to be formed as a conductive fine pattern.

In an embodiment, the insulation area may include a plurality of line-shaped areas that are spaced apart from each other, and the conductive area may include areas between the plurality of line-shaped areas.

In an embodiment, the photocurable ink may be discharged through a plurality of nozzles of a first ejection head, which are arranged in a direction perpendicular to the path, the volatile ink may be discharged through a plurality of nozzles of a second ejection head, which are arranged in a direction perpendicular to the path, and the plurality of nozzles of the first ejection head and the plurality of nozzles of the second ejection head may be alternately arranged based on the path.

In an embodiment, the plurality of nozzles of the first ejection head and the plurality of nozzles of the second ejection head may be alternately arranged so that an outermost nozzle of the second ejection head is disposed at an inner side of an outermost nozzle of the first ejection head.

In an embodiment, the first ejection head and the second ejection head may have the same width to cover an entire width of the substrate and are arranged in series in front and rear directions of the path.

In order to achieve the technical objects, the present invention provides an apparatus for forming a conductive fine pattern, which forms a conductive fine pattern on a substrate having identical surface energy by using an inkjet printing for printing an ink along a path, including: a first ejection head configured to eject a photocurable ink at a front side of the path; a second ejection head configured to eject a volatile ink containing minute metal particles at a rear side of the path at the same time with the first ejection head; and a light irradiator configured to apply light energy to the photocurable ink discharged from the first ejection head. Here, an intensity of the light energy of the light irradiator is set so that the gelled photocurable ink that is traveling and discharged from the first ejection head is ejected on the substrate to form a boundary with the ejected volatile ink discharged from the second ejection head and simultaneously prevent the photocurable ink from being spread, thereby being completely cured after all of the photocurable ink and the volatile ink are completely ejected.

In an embodiment, the first ejection head may be configured to eject a photocurable ink droplet of 2 pL or less onto an insulation area to be formed as a non-conductive area of the substrate, and the second ejection head may be configured to eject a volatile ink droplet of 2 pL or less onto a conductive area to be formed as a conductive fine pattern of the substrate.

In an embodiment, the non-conductive area may include a plurality of areas that are spaced apart from each other, and the conductive area may include areas between the non-conductive areas.

In an embodiment, the photocurable ink may be discharged through a plurality of nozzles of a first ejection head, which are arranged in a direction perpendicular to the path, the volatile ink may be discharged through a plurality of nozzles of a second ejection head, which are arranged in a direction perpendicular to the path, and the plurality of nozzles of the first ejection head and the plurality of nozzles of the second ejection head may be alternately arranged based on the path.

In an embodiment, the plurality of nozzles of the first ejection head and the plurality of nozzles of the second ejection head may be alternately arranged so that an outermost nozzle of the second ejection head is disposed at an inner side of an outermost nozzle of the first ejection head.

In an embodiment, the first ejection head and the second ejection head may have the same width to cover an entire width of the substrate and are arranged in series in front and rear directions of the path.

### ADVANTAGEOUS EFFECTS

The above-described present invention has an advantage of quickly manufacturing the substrate having the fine pattern smaller than 20 µm by simplifying all processes using the inkjet printing method.

The objects of the present invention are not limited to the aforementioned object, but other objects not described herein will be clearly understood by those skilled in the art from descriptions below.

### BRIEF DESCRIPTION OF THE DRAWINGS

FIG. 1 is a view for explaining an operation of a main component of an apparatus for forming a conductive fine pattern according to an embodiment of the present invention.
FIG. 2 is a flowchart illustrating an order of a method for forming a conductive fine pattern according to an embodiment of the present invention.
FIG. 3 is a schematic view illustrating the apparatus for forming the conductive fine pattern according to an embodiment of the present invention.
FIG. 4 is a schematic view illustrating an apparatus for forming a conductive fine pattern according to another embodiment of the present invention.

### MODE FOR CARRYING OUT THE INVENTION

The present invention may be carried out in various embodiments without departing from the technical ideas or primary features. Therefore, embodiments of the present invention are merely illustrative, but should not be limitedly interpreted.

It will be understood that although the terms such as 'first' and 'second' are used herein to describe various elements, these elements should not be limited by these terms.

The terms are only used to distinguish one component from other components. For example, a first element referred to as a first element in one embodiment can be referred to as a second element in another embodiment without departing from the scope of the appended claims.

As used herein, the term and/or includes any and all combinations of one or more of the associated listed items.

It will also be understood that when an element is referred to as being "`connected to" or "engaged with" another element, it can be directly connected to the other element, or intervening elements may also be present.

It will also be understood that when an element is referred to as being 'directly connected to' another element, there is no intervening elements.

In the following description, the technical terms are used only for explaining a specific exemplary embodiment while not limiting the present invention. The terms of a singular form may include plural forms unless referred to the contrary.

The meaning of `include' or 'comprise' specifies a property, a number, a step, a process, an element, a component, or a combination thereof in the specification but does not exclude other properties, numbers, steps, processes, elements, components, or combinations thereof.

Unless terms used in the present disclosure are defined differently, the terms may be construed as meaning known to those skilled in the art.

Terms such as terms that are generally used and have been in dictionaries should be construed as having meanings matched with contextual meanings in the art. In this description, unless defined clearly, terms are not ideally, excessively construed as formal meanings.

Hereinafter, embodiments disclosed in this specification is described with reference to the accompanying drawings, and the same or corresponding components are given with the same drawing number regardless of reference number, and their duplicated description will be omitted.

Moreover, detailed descriptions related to well-known functions or configurations will be ruled out in order not to unnecessarily obscure subject matters of the present invention.

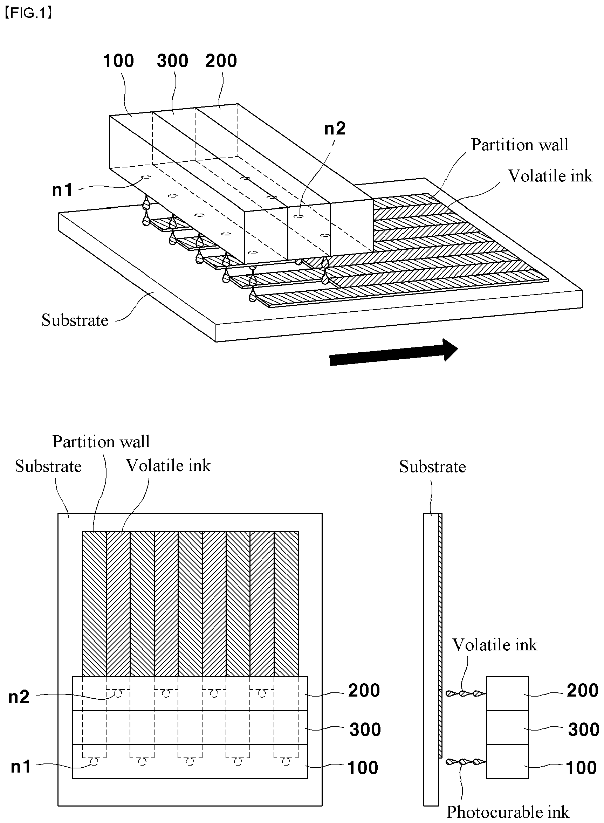

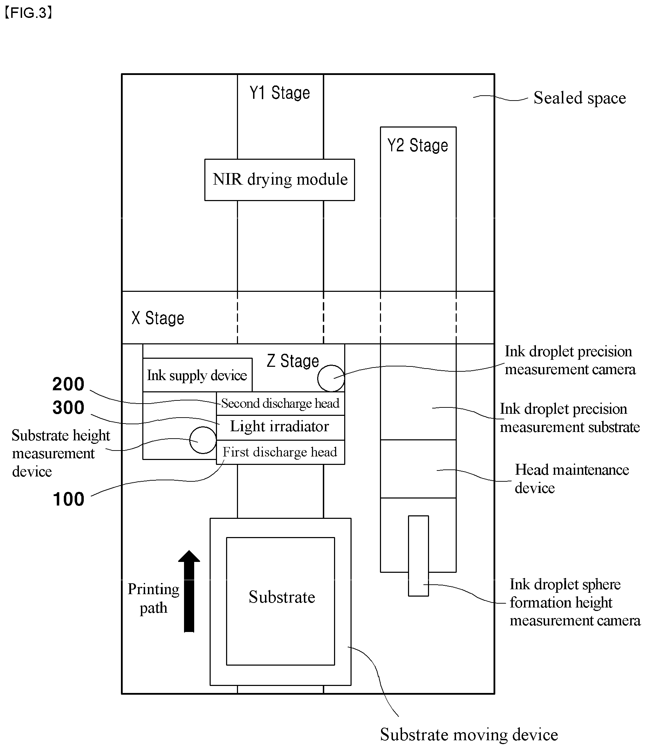

An apparatus for forming a conductive fine pattern (hereinafter, referred to as a conductive fine pattern forming apparatus) according to an embodiment of the present invention, which forms a conductive fine pattern on a substrate having identical surface energy by using an inkjet printing method for jetting an ink along a printing path, includes main components of a first ejection head 100, a second ejection head 200, and a light irradiator 300. A detailed configuration including the main components will be described with reference to FIGS. 1 and 3.

As illustrated in FIGS. 1 and 3, the conductive fine pattern forming apparatus includes a substrate moving device for moving a substrate to form a conductive fine pattern thereon, a first ejection head 100 for discharging a photocurable ink at a front side of a movement direction of the substrate, a light irradiator 300 disposed directly behind the first discharge head 100, and a second discharge head 200 disposed at a rear side of the movement direction of the substrate for discharging a volatile ink containing minute metal particles.

The first discharge head 100, the light irradiator 300, and the second discharge head 200 are directly adj acent to each other in order.

Particularly, as a photocurable ink discharged and traveling from the first discharge head 100 is ejected in a gel state onto the substrate, the photocurable ink forms a boundary with a volatile ink discharged and ejected from the second discharge head 200, and spreading of the photocurable ink is prevented. The light irradiator 300 has an light energy intensity that is set so that the photocurable ink is completely cured after all of the photocurable ink and the volatile ink are completely ejected.

Specifically, as the volatile ink is discharged from the second discharge head 200 before the photocurable ink discharged from the first discharge head 100 is ejected on the substrate and completely cured, and thus the volatile ink is ejected before the photocurable ink is ejected on the substrate and completely spread, the spreading of the photocurable ink may be prevented, and an area on which the photocurable ink is ejected is reduced.

As illustrated in FIGS. 1 and 3, each of the first discharge head 100 and the second discharge head 200 has a length enough to cover an entire width of the substrate to form a pattern on an entire area of the substrate through one-time printing process.

Here, the first discharge head 100 and the second discharge head 200 have the same length and are arranged in serial in front and rear directions of the path.

The first discharge head 100 may include a plurality of nozzles n1 arranged in a direction perpendicular to the path and eject a photocurable ink droplet having a volume of 2 picoliters (pL) or less onto an insulation area to be formed as a non-conductive area of the substrate. Alternatively, the first discharge head 100 may eject a photocurable ink droplet having a volume of 0.6 pL or less according to an inkjet discharge atmosphere (a helium gas atmosphere).

The second discharge head 200 may include a plurality of nozzles n2 arranged in a direction perpendicular to the path and eject a volatile ink droplet having a volume of 2 pL or less onto a conductive area to be formed as the conductive fine pattern of the substrate. Alternatively, the second discharge head 200 may eject a volatile ink droplet having a volume of 0.6 pL or less according to an inkjet discharge atmosphere (a helium gas atmosphere).

Here, as illustrated in FIG. 1, the plurality of nozzles n1 of the first discharge head 100 and the plurality of nozzles n2 of the second discharge head 200 are alternately arranged based on the path, and particularly, alternately arranged to have a difference as many as a half of a resolution pitch to be printed.

Here, an outermost nozzle n2 of the second discharge head 200 is disposed at an inner side of an outermost nozzle n1 of the first discharge head 100 from which the photocurable ink is discharged so that the photocurable ink is discharged on four edges of the substrate to prevent the volatile ink discharged from the second discharge head 200 from flowing to the outside of the substrate.

The non-conductive area includes a plurality of linear areas that are spaced apart from each other, the conductive area may include linear areas disposed between the non-conductive areas, and each of the non-conductive area and the conductive area may be a preset virtual area disposed on a surface of the substrate, particularly a surface of the substrate having identical surface energy.

As illustrated in FIG. 3, the substrate moving device performs a linear movement (an upward movement in the drawing) of the substrate along an Y1 stage.

An ink droplet precision measurement camera and a substrate height measurement device in addition to the first discharge head 100, the light irradiator 300 and the second discharge head 200 are installed on a Z stage that vertically moves to move together, and the Z stage moves linearly along a X stage.

The vertical movement of the Z stage and the movement of the Z stage along the X-stage may be performed by a driving unit such as a linear motor and a linear guide.

As described above, the first discharge head 100, the light irradiator 300 and the second discharge head 200 are assembled to the Z stage and move together by one driving unit.

An Y2 stage is disposed next to and parallel to the Y1 stage, and an ink droplet precision measurement substrate for measuring a precision of an ejected ink droplet discharged from each of the first discharge head 100 and the second discharge head 200 is disposed on the Y2 stage.

Also, a head maintenance device for maintaining the first discharge head 100 and the second discharge head 200 is disposed on the Y2 stage.

Also, an ink droplet sphere formation height measurement camera for measuring a sphere formation height of an ink droplet discharged from each of the first discharge head 100 and the second discharge head 200 is disposed on the Y2 stage.

All of the ink droplet precision measurement substrate, the head maintenance device, and the ink droplet sphere formation height measurement camera are assembled into one body to linearly move along the Y2 stage.

Also, a NIR drying module may be installed at a rear side of the Y1 stage for speed and convenience of a process of drying the substrate moving along the Y1 stage and for quick performing a printing process of the volatile ink a plurality of times.

The above-described inkjet printing device may be installed in a sealed space having a helium gas atmosphere, and a process of forming a gelled partition wall by discharging the photocurable ink from the first discharge head 100 and a process of forming the conductive pattern by inkjet-discharging volatile liquid between the gelled partition walls from the second discharge head 200 may be performed under the helium gas atmosphere.

The above-described inkjet printing device may be installed in the enclosed space having the helium gas atmosphere to perform the process of forming the conductive pattern under the helium gas atmosphere, thereby inkjet-discharging the photocurable ink from the first discharge head 100 in the form of an ink droplet having a smaller size and inkjet-discharging the volatile ink from the second discharge head 200 in the form of an ink droplet having a smaller size.

Specifically, since helium has a density (0.1785 kg/m3) that is about 15% of a density (1.2 kg/m3) of air, a terminal velocity of the ink droplet may be improved. More specifically, the helium atmosphere may reduce air (gas) resistance to maintain a sufficient discharge speed and a sufficient traveling distance due to a low molecular weight of the helium although an ink droplet having a volume of 0.6 pL or less is discharged.

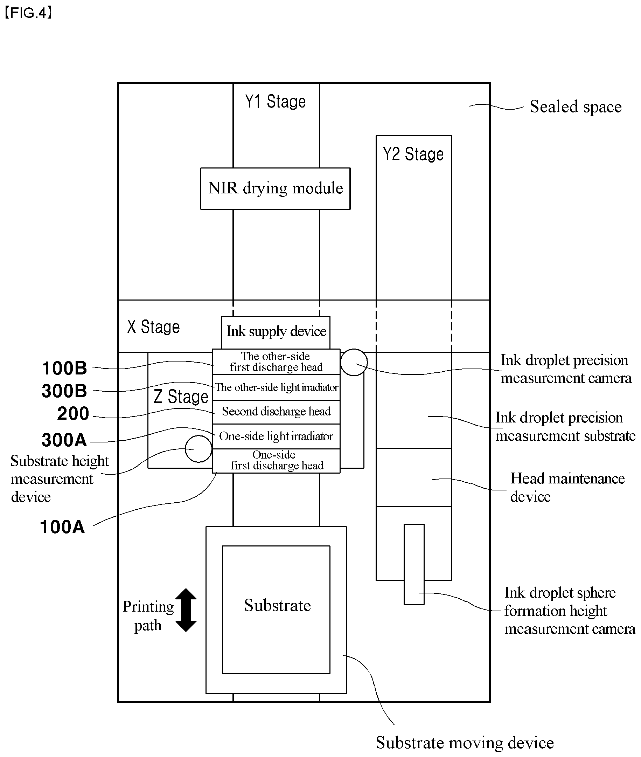

As illustrated in FIG. 4, a conductive fine pattern forming apparatus according to another embodiment of the present invention includes main components of one-side first discharge head 100A, one-side light irradiator 300A, a second discharge head 200, the other- side light irradiator 300B, and the other-side first discharge head 100B, which are arranged in series and sequentially next to each other and will be described with reference to FIG. 4.

As illustrated in FIG. 4, the conductive fine pattern forming apparatus according to another embodiment of the present invention includes a substrate moving device that performs a linear movement of a substrate in both directions along an Y1 stage.

That is, the substrate moving device allows the substrate to move toward an upper side or lower side of the drawing or move in both directions of the drawing.

For example, when the substrate moving device allows the substrate to move from the lower side to the upper side of the drawing based on a X stage, a pattern is formed by operating the one-side first discharge head 100A discharging the photocurable ink at a front side of a movement direction of the substrate, the one-side light irradiator 300A disposed adjacent to the one-side first discharge head 100A, and the second discharge head 200 disposed at a rear side of the movement direction of the substrate and discharging the volatile liquid.

On the contrary, when the substrate moving device allows the substrate to move from the upper side to the lower side of the drawing based on the X stage, a pattern is formed by operating the other-side first discharge head 100B discharging the photocurable ink at the front side of a movement direction of the substrate, the other-side light irradiator 300B disposed adjacent to the one-side first discharge head 100B, and the second discharge head 200 disposed at a rear side of the movement direction of the substrate and discharging the volatile liquid.

When the conductive fine pattern forming apparatus according to another embodiment of the present invention performs inkjet printing on one substrate a plurality of times, the ink may be printed on the substrate while the substrate moves reciprocately from the lower side to the upper side and from the upper side to the lower side based on the X stage, and a movement path of the substrate may be shorter than that of the previously described embodiment to allow a faster operation.

The arrangement relationship between the nozzles of the first discharge head 100 and the second discharge head 200 according to the previously described embodiment will be equally applied to an arrangement relationship between nozzles of the one-side first discharge head 100A and the second discharge head 200 and an arrangement relationship between nozzles of the other-side first discharge head 100B and the second discharge head 200.

Hereinafter, a method for forming a conductive fine pattern by using the above-described conductive fine pattern forming apparatus according to an embodiment of the present invention will be described in detail.

The method for forming the conductive fine pattern that form the conductive fine pattern on a substrate having identical surface energy by using an inkjet printing for printing an ink along a path may include a droplet ejection process, a drying process, a thick film process, a curing process and a partition wall removing process.

Firstly, the droplet ejection process will be described.

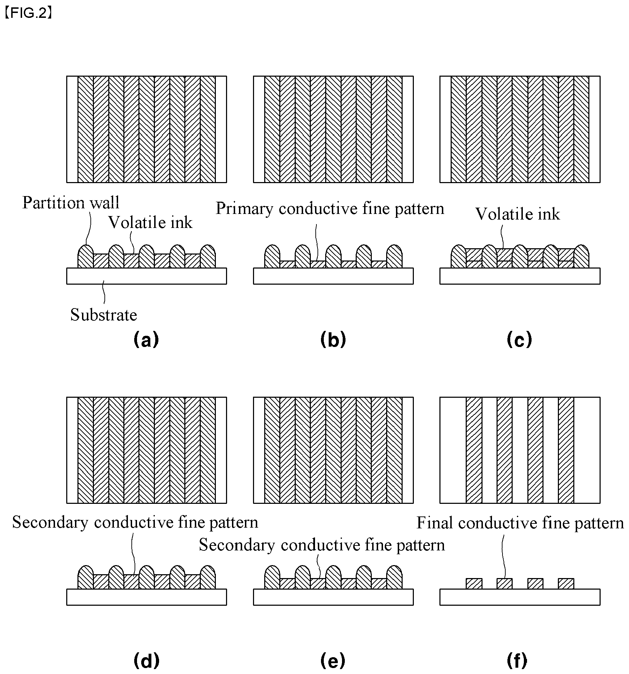

As illustrated in (a) of FIG. 2, the droplet ejection process simultaneously performs all of discharging a photocurable ink through a first discharge head 100 at a front side of a printing path, discharging a volatile ink containing minute metal particles through a second discharge head 200 at a rear side of the printing path, and applying light energy through a light irradiator 300 to the discharged photocurable ink.

Particularly, in the droplet ejection process, an intensity of the light energy is set so that a gelled partition wall is formed as the photocurable ink in a semi-cured and gel state is ejected on the substrate to form a boundary with the liquid-state volatile ink ejected on the substrate and simultaneously prevent the photocurable ink from being spread, and the photocurable ink is completely cured after all of the photocurable ink and the volatile ink are completely ejected.

Through this, as the volatile ink is ejected before the photocurable ink is ejected on the substrate and completely spread to prevent the photocurable ink from being spread, an effect of reducing an area on which the photocurable ink is ejected is generated.

That is, as the light energy applied to the discharged photocurable ink is set as described above, the photocurable ink in a semi-cured and gel state instead of a completely cured state is ejected to form the partition walls, and the volatile ink is ejected between the partition walls before the gelled partition wall is spread on the substrate to prevent the gelled partition wall from being spread.

More specifically, a typical droplet ejection process forms completely cured partition walls after a photocurable ink is discharged on a substrate and then form a conductive patter by ejecting a volatile ink between the partition walls. In this case, since the photocurable ink is ejected on the substrate and then spread until being cured, each of the partition walls may have a big thickness, and thus conductive patterns may not have a fine spaced distance therebetween.

In an embodiment of the present invention, the volatile ink is ejected between the partition walls before the gelled partition wall made of the ejected photocurable ink is spread on the substrate to prevent the gelled partition wall from being spread, a thickness of the partition wall may be reduced, and thus the conductive patterns may have a fine spaced distance therebetween.

Each of the photocurable ink discharged from the first discharge head 100 and the volatile ink discharged from the second discharge head 200 may be discharged with a droplet size of 2 pL or less (0.6 pL or less under the helium gas atmosphere), the photocurable ink may be ejected on the insulation area to be formed as the non-conductive area, and the volatile may be ejected on the conductive area to be formed as the conductive fine pattern.

Each of the insulation area and the conducive area may be defined as a preset virtual area on the substrate having identical surface energy.

Specifically, as illustrated in (a) of FIG. 2, the insulation area includes a plurality of linear areas that are spaced apart from each other, and the conductive area include linear areas between the insulation areas.

As illustrated in FIG. 1, the photocurable ink may be discharged through the plurality of nozzles n1 of the first discharge head 100 arranged in a direction perpendicular to the path, and the volatile ink may be discharged through the plurality of nozzles n2 of the second discharge head 200 arranged in the direction perpendicular to the path, and the plurality of nozzles n1 of the first discharge head 100 and the plurality of nozzles n2 of the second discharge head 200 may be alternately arranged based on the path.

Next, the drying process will be described.

The drying process is performed to dry the volatile ink after the droplet ejection process. As illustrated in (b) of FIG. 2, the volatile ink ejected on the substrate is dried to form a primary conductive fine pattern on the substrate by the minute metal particles.

Next, the thick film process will be described.

As illustrated in (c) and (d) of FIG. 2, after the drying process, the thick film process that is for thickening a pattern by additionally ejecting the volatile ink onto the primary conductive fine pattern formed by the drying of the volatile ink and then additionally drying the additionally ejected volatile ink to form a secondary conductive fine pattern, thereby thickening a thickness of the entire pattern. The thick film process may be performed at least one time or omitted.

Finally, after the above-described processes are finished, the curing process of curing the secondary conductive fine pattern as illustrated in (e) of FIG. 2 and the partition wall removing process of removing the partition wall as illustrated in (f) of FIG. 2 may be additionally performed. When all of the above-described processes are finished, the substrate on which a final conductive fine pattern is formed may be obtained.

Although the embodiments of the present invention have been described, it is understood that the present invention should not be limited to these embodiments but various changes and modifications can be made by one ordinary skilled in the art within the spirit and scope of the present invention as hereinafter claimed.
The present invention is supported by the national research and development program stated below.
Project identification number: 1415178203
Project number: 20010442
Department name: Ministry of Trade, Industry and Energy
Project management (professional) organization name: Korea Institute of Industrial Technology Evaluation and Planning
Research program title: Materials and parts industry future growth engine (R&D)
Research project title: Technology development of display integrated 5G millimeter wave antenna over 28GHz for mobile display
Contribution ratio: 1/1
Project execution organization name: UniJet Co., Ltd.
Research period: 2020.04.01 ~ 2023.12.31

## Claims

1. A method for forming a conductive fine pattern, which forms a conductive fine pattern on a substrate having identical surface energy by using an inkjet printing for printing an ink along a path, comprising a droplet ejection process of simultaneously performing all of discharging a photocurable ink at a front side of the path, discharging a volatile ink containing minute metal particles at a rear side of the path, and applying light energy to the discharged photocurable ink,
wherein a light intensity of the light energy is set so that the photocurable ink in a semi-cured and gel state is ejected on the substrate to form a boundary with the liquid volatile ink ejected on the substrate and simultaneously prevent the photocurable ink from being spread, thereby being completely cured after all of the photocurable ink and the volatile ink are completely ejected.

2. The method of claim 1, further comprising a drying process of drying the volatile ink after the droplet ejection process.

3. The method of claim 2, wherein, after the drying process, a thick film process of additionally ejecting and drying the volatile ink onto the conductive fine pattern formed by the drying of the volatile ink is performed at least one time.

4. The method of claim 1, wherein each of the photocurable ink and the volatile ink is discharged with a droplet size of 2 picoliter (pL) or less,
wherein the photocurable ink is ejected on an insulation area to be formed as a non-conductive area, and the volatile ink is ejected on a conductive area to be formed as a conductive fine pattern.

5. The method of claim 4, wherein the insulation area comprises a plurality of line-shaped areas that are spaced apart from each other, and the conductive area comprises areas between the plurality of line-shaped areas.

6. The method of claim 1, wherein the photocurable ink is discharged through a plurality of nozzles of a first discharge head, which are arranged in a direction perpendicular to the path,
the volatile ink is discharged through a plurality of nozzles of a second discharge head, which are arranged in a direction perpendicular to the path, and
the plurality of nozzles of the first discharge head and the plurality of nozzles of the second discharge head are alternately arranged based on the path.

7. The method of claim 6, wherein the plurality of nozzles of the first discharge head and the plurality of nozzles of the second discharge head are alternately arranged so that an outermost nozzle of the second discharge head is disposed at an inner side of an outermost nozzle of the first discharge head.

8. The method of claim 6, wherein the first discharge head and the second discharge head have the same width to cover an entire width of the substrate and are arranged in series in front and rear directions of the path.

9. An apparatus for forming a conductive fine pattern, which forms a conductive fine pattern on a substrate having identical surface energy by using an inkjet printing method of printing an ink along a path, comprising:
a first discharge head configured to eject a photocurable ink at a front side of the path;
a second discharge head configured to eject a volatile ink containing minute metal particles at a rear side of the path at the same time with the first discharge head; and
a light irradiator configured to apply light energy to the photocurable ink discharged from the first discharge head,
wherein an intensity of the light energy of the light irradiator is set so that the gelled photocurable ink that is traveling and discharged from the first discharge head is ejected on the substrate to form a boundary with the ejected volatile ink discharged from the second discharge head and simultaneously prevent the photocurable ink from being spread, thereby being completely cured after all of the photocurable ink and the volatile ink are completely ejected.

10. The apparatus of claim 9, wherein the first discharge head is configured to eject a photocurable ink droplet of 2 pL or less onto an insulation area to be formed as a non-conductive area of the substrate, and
the second discharge head is configured to eject a volatile ink droplet of 2 pL or less onto a conductive area to be formed as a conductive fine pattern of the substrate.

11. The apparatus of claim 10, wherein the non-conductive area comprises a plurality of areas that are spaced apart from each other, and the conductive area comprises areas between the non-conductive areas.

12. The apparatus of claim 9, wherein the photocurable ink is discharged through a plurality of nozzles of a first discharge head, which are arranged in a direction perpendicular to the path,
the volatile ink is discharged through a plurality of nozzles of a second discharge head, which are arranged in a direction perpendicular to the path, and
the plurality of nozzles of the first discharge head and the plurality of nozzles of the second discharge head are alternately arranged based on the path.

13. The apparatus of claim 12, wherein the plurality of nozzles of the first discharge head and the plurality of nozzles of the second discharge head are alternately arranged so that an outermost nozzle of the second discharge head is disposed at an inner side of an outermost nozzle of the first discharge head.

14. The apparatus of claim 12, wherein the first discharge head and the second discharge head have the same width to cover an entire width of the substrate and are arranged in series in front and rear directions of the path.
